# EUROPEAN PATENT APPLICATION

(11) **EP 0 604 168 A1**
(43) Date of publication of application: **29.06.1994**
(21) Application number: 93310323.6
(22) Date of filing: 20.12.1993
(51) Int. Cl.: H03M 1/36

(54) **Cascadable flash analog-digital converters**

(30) Priority: 19.12.1992 GB 9226608
(71) Applicant: MMS SPACE SYSTEMS LIMITED, Stanmore, Middlesex HA7 4LY (GB)
(72) Inventor: Tichborne, Frank, British Aerospace Space Sys.Ltd., Bristol BS12 7QW (GB); Mitchell,Scott, British Aerospace Space Sys.Ltd, Bristol BS12 7QW (GB)
(74) Representative: Waters, Jeffrey

(57) **Abstract**

An analogue to digital converter for converting an analogue input signal which lies within an analogue input range, comprises a stack of comparator circuits (12, 42) each corresponding to a subrange of said analogue input range, wherein said converter (10, 40) is operable to provide a digital output signal defining the subrange containing said analogue input signal (Vᵢₙ), and an analogue output signal or signals defining the position of said analogue input signal within said subrange, said analogue output signal or signals being derived from the inputs to said comparator circuits (12, 42).

## Description

This invention relates to analogue to digital converters and in particular but not exclusively to cascadable flash analogue to digital converters.

Normally a flash converter requires 2ⁿ comparator circuits for an n-bit conversion; hence an eight bit analogue to digital converter needs 255 comparators. The advance of monolithic technology and small feature sizes has enabled up to 10 bit analogue to digital converters to be made, but to advance to a 16 bit is believed to be impractical, not only due to the 65535 comparators needed but also to the loading on the internal analogue buffered input signal which would have to compensate for 65535 leakage circuits.

It has been proposed to employ cascaded designs to reduce the number of comparator circuits required and the loading on the buffered input. However, these normally require that a first flash analogue to digital converter generates the most significant (say) 8 bits, then an 8 bit digital to analogue converter converts the result back to analogue, which automatically rounds the output voltage down. A difference amplifier then amplifies the difference between the rounded down signal and the input. This difference is then converted to form the lesser significant bits. This method has a number of disadvantages in that errors in the digital to analogue converter and delays in the circuit make it a less than satisfactory solution, and in particular the top end of the lower significant conversion is not guaranteed not to underlap or overlap the next transition of the most significant byte without accurate trimming.

We have found that at least some of the difficulties encountered with previous proposals may be obviated if the analogue signals supplied to the downstream converter of a cascade are derived in analogue manner from the upstream converter, without back conversion of the digital signal.

Accordingly, in one aspect, this invention provides an analogue to digital converter for converting an analogue input signal which lies within an analogue input range, characterised in that said converter comprises a stack of comparator circuits each corresponding to a subrange of said analogue input range, wherein said converter is operable to provide a digital output signal defining the subrange containing said analogue input signal, and an analogue output signal or signals defining the position of said analogue input signal within said subrange, said analogue output signal or signals being derived from the inputs to said comparator circuits.

In another aspect, this invention provides an analogue to digital converter for converting an analogue input signal which lies within an analogue input range, characterised in that said converter comprises:-
a stack of comparator circuits each including two inputs and an output;
input means for supplying said analogue input signal to said comparator circuits for comparison;
subreference generating means for providing a scale of subreference signals defining a plurality of subranges of said analogue input range and for supplying said subreference signals to corresponding comparator circuits;
digital output means responsive to the output stages of said comparator circuits for providing a digital number corresponding to the subrange containing the analogue input signal, and
analogue output means responsive to the states of the comparator circuits for providing an analogue output signal or set of signals which is or are derived from at least one of the subreference signals defining the subrange containing said analogue input signal, and which indicates the position of said analogue signal within said subrange.

In the above arrangements, the analogue output signals for further conversion by the downstream converter are derived in analogue fashion from the analogue signals employed in the upstream converter and there is no back conversion of the digital output. Furthermore, the downstream converter is supplied with a signal or signals representing the position of the analogue input within the subrange rather than a comparison of the analogue input signal and the digital to analogue converted result of the first digitisation.

The analogue output signals may be in a variety of forms, depending in particular on how the subreference signals are derived. Thus, the analogue output signals may include one or more of the following; a signal representing the lower limit of the analogue input range, and a signal representing the upper limit of the analogue input range.

The analogue to digital converter preferably includes means for receiving reference signals defining the upper and lower limits of the analogue input range. The subreference generating means preferably responds to the upper and lower limits to provide said subreference signals which divide the input range into a number of subranges corresponding to the number of comparator circuits. This division may be achieved in different ways. In one example a voltage signal corresponding to the analogue input range is applied across a chain of resistive elements and a voltage signal from between each adjacent two resistive elements is supplied to a corresponding comparator circuit. Preferably each comparator circuit receives an upper and a lower subreference signal taken from either side of the corresponding resistive element and defining the bounds of the associated subrange. The comparator circuits preferably include logic circuitry which supplies to said analogue output means the upper and lower subreference signals of the active comparator circuit immediately above the highest comparative circuit "set". The logic circuitry preferably also flags said active comparator circuit for identifying the appropriate digital number to the output by said output means.

In another example, the reference chain may be a chain of capacitive elements preferably with a switching arrangement for charging the capacitative elements in parallel and then connecting the elements in series. The capacitive elements are preferably charged with a divided input reference signal. In this system the total voltage across the capacitors when in series should be kept close to the input reference voltage. This may be achieved by using an accurate voltage divider or using closed loop successive approximation during non-conversion time.

Whilst the invention has been described above it includes any inventive combinations of the features set out above or in the following description.

The invention may be performed in various ways and an embodiment will now be described in detail, reference being made to the accompanying drawings, in which:-
Figure 1 is a block diagram of a first embodiment of a cascadable flash analogue to digital converter in accordance with the invention and incorporating a reference chain of resistors;
Figure 2 is a block diagram of a second embodiment of a cascadable flash analogue to digital converter in accordance with the invention and incorporating a reference chain of capacitors, and
Figure 3 is a block diagram illustrating two converters of the type shown in Figure 1, cascaded together.

In the illustrated examples, a 16 bit analogue to digital converter is formed by using two cascaded 8 bit devices with special cascade connections to make the sub-conversion monotonic with the top conversion. This reduces the number of comparators needed to (2^{m}-1) x r where m = number of bits in the partial converter and r = number of cascades. For the illustrated case this would be 510, much easier to accomplish than the 65535 that would be required by a non-cascaded flash converter. The technique however is generic in that, for example, a 15 bit conversion could be produced using three 5-bit converters.

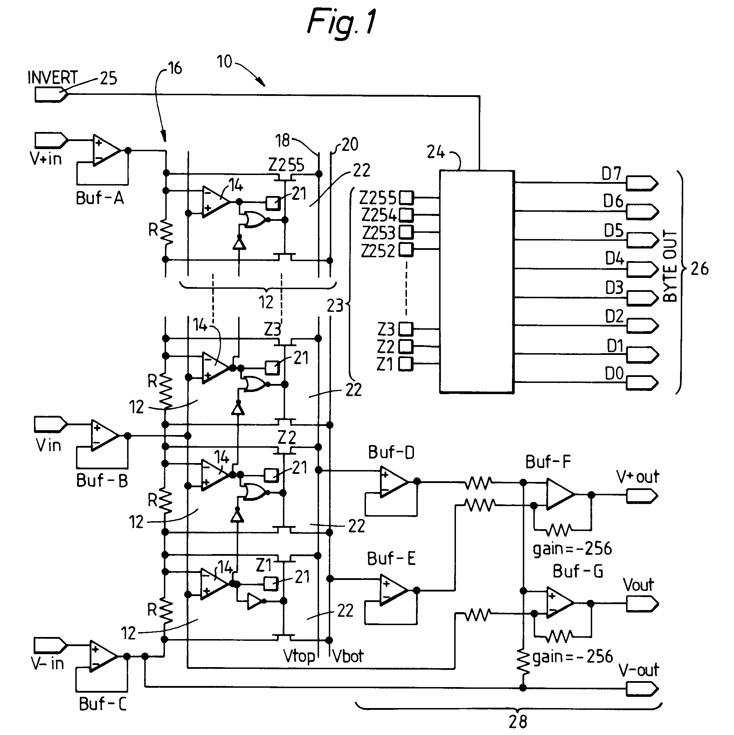

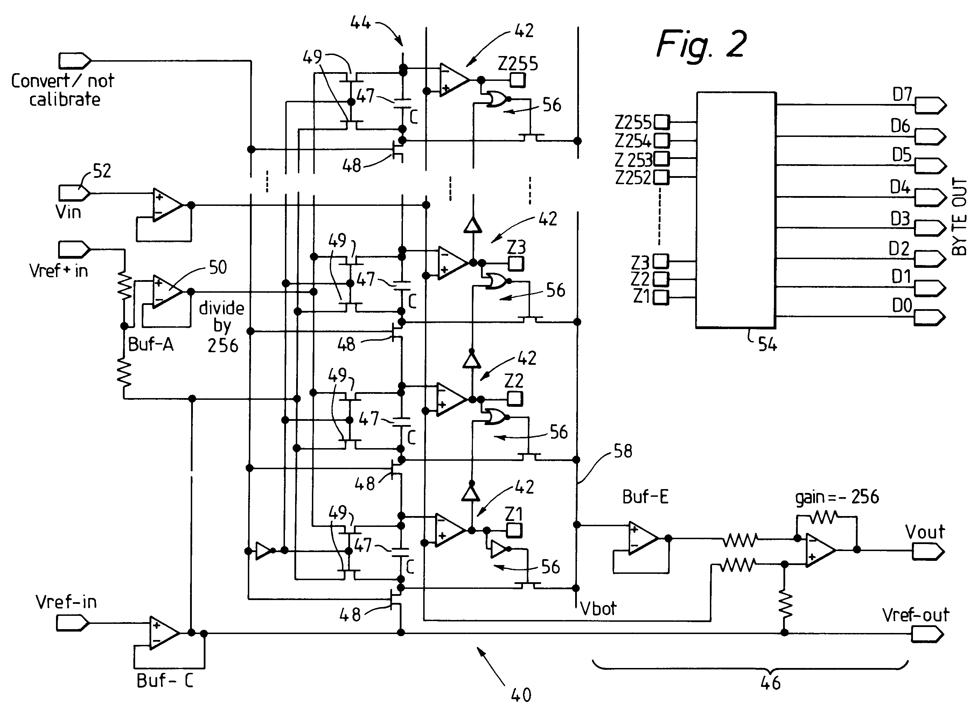

In the embodiment shown in Figures 1 and 2, an analogue input signal (Vᵢₙ) is supplied to the 8 bit converter with two analogue reference signals (V_{ref=in}) and V _{ref-in}) which define the analogue input range. The converter provides an 8 bit number which defines the position of the analogue signal within the analogue range, in terms of the subrange or quantum occupied by the analogue signal. The converter also provides a set of analogue output signals which indicates the position of the analogue signal within the subrange. This set of analogue output signals is amplified and then supplied to a further analogue to digital converter where it is converted to form the remaining 8 bits of the 16 bit word.

Referring to Figure 1, the converter 10 comprises a stack of 255 comparator circuits 12 each comprising a differential amplifier 14. The non-inverting input of each amplifier 14 receives a common buffered input analogue signal (Vᵢₙ), whilst the inverting input receives a respective subreference signal which is tapped from a reference chain 16 of resistors (R) connected between the top voltage reference (V₊ᵢₙ) and the bottom voltage reference (V₋ᵢₙ). The reference chain provides a scale of subreference signals which defines 255 equal subranges. Thus each comparator circuit 12 is identified with a particular subrange of the analogue input range. The upper and lower subreference values defining the subrange of a particular comparator circuit are connected to upper and lower subreference rails 18, 20 via switching arrangements 22. The switching arrangements are operated by a logic circuit so that only the upper and lower subreference values of the subrange occupied by the signal are switched to the upper and lower subreference rails 18, 20. In other words, only the subreference values of the comparator circuit 12 immediately above the highest comparator circuit set are switched. The outputs 21 of all the comparator circuits 12 are supplied to corresponding input terminals 23 of an inverting priority encoder 24. The encoder 24 monitors those input terminals which are high and thereby provides at 26 an 8 bit word corresponding to the level of the analogue signal relative to the input range. This digital output indicates the eight most significant bits.

At the analogue output stage 28, an output set of three signals is provided as follows:-

An output voltage (V₊ₒᵤₜ) equal to 256 times the difference between the upper active comparator element voltage and the lower active comparator element voltage.

An output voltage (Vₒᵤₜ) equal to 256 times the difference between the upper active comparator element voltage and the input signal.

A negative reference (V₋ₒᵤₜ) equal to the input negative reference voltage (buffered).

Since the Vₒᵤₜ signal goes down as the input volts (Vᵢₙ) increase then the second cascade needs to invert the digital priority encoder, and this is done by applying an invert signal to the encoder 24 via invert terminal 25. Thus, all odd cascades are inverting, and even cascades are non-inverting.

In operation, the analogue input signal supplied to the converter is fed to all the comparator circuits in parallel and each comparator compares the input signal with its subrange. If the analogue input is above the subrange the comparator sends to the encoder a high signal. Thus all the comparators in the stack corresponding to subranges below the analogue input will output high signals, and the comparator corresponding to the subrange containing the analogue input will output a low signal, as will all the comparators above that one. The low signal from the comparator whose subrange embraces the analogue input, and the high signal from the next lower comparator will make the logic circuitry close the transistor switches to supply analogue voltage levels corresponding to the upper and lower limits of the subrange to the analogue output stage for processing as detailed above.

It is important to ensure that the amplifiers are properly matched and that very low input offset comparators and operational amplifiers are used.

There will also be a small skew between the first and lower order conversions and hence an extra sample and hold stage may be incorporated for the whole cascade, to ensure that monotonic operation is maintained at the maximum frequency of operation.

In the embodiment of Figure 1, a resistor chain is used to generate the subreference voltages for each comparator. However this reference chain could also be a series of capacitors, with a switching arrangement for charging to the subreferences in parallel from an accurately divided input reference. This arrangement is shown in Figure 2.

In this second embodiment 40 the comparator circuits 42 are of similar form except that the subreference voltage is obtained from the capacitor chain 44 and also only the lower subreference value, i.e. that defining the lower limit of the subrange is supplied to the analogue output stage 46.

The reference chain 44 includes a series of capacitors 47 disposed alternately with switching transistors 48. Across each capacitor 47 is applied a reference voltage via switching transistors 49. The switching transistors 48 are made conducting alternately with transistors 49 so that, during a calibration phase, the same reference is applied across each capacitor 47 in parallel. During a conversion phase, the transistors 48 are conducting so that they are in series. The common reference voltage applied across the capacitors is obtained by dividing the input reference voltage V _{ref+in} by the number of comparator circuits, by adjusting the gain of buffer amplifier 50.

In operation, during the conversation phase, each comparator is supplied via the common input 52 with the analogue input voltage. All those comparator circuits corresponding to subranges below the analogue input provide an output signal to the inverting priority encoder 54. As before, this provides a digital signal corresponding to the eight most significant bits. The comparator circuit immediately above the highest circuit "set" supplies via the logic switching circuit 56 its lower subreference value to the analogue output stage 46 via a lower subreference rail 58. At the analogue output stage 46, the lower subreference value is subtracted from the analogue input signal to provide an analogue output signal Vₒᵤₜ to the next converter in the cascade. Also supplied to the next converter is the analogue input reference signal defining the lower limit of the analogue input range (V _{ref-out}).

This second embodiment does not require the generation of a reference output since the voltage on each capacitor is guaranteed to be equal, as they were all charged up in parallel. Instead the input reference could be used for all cascades. A possible disadvantage with this method is that some of the conversion cycle is required to switch the reference chain from serial to parallel to charge the subreference and then switch back to serial again. This could be overcome by the addition of a second bank of capacitors which would be regularly charged in parallel and then switched into series and connected to the main reference chain to equalise their voltages with the main reference chain so that the main reference chain could be used continuously, with only top up charging. The advantage with the capacitor version is that it would be more linear, since variations in capacitor values would not affect their charged voltage.

In order to increase the monotonicity of the cascaded output (with capacitors), the reference total should be kept as near as possible to the input reference. This can either be achieved by using an accurate voltage divider to generate the subreferences or by generating the subreferences as a closed loop successive approximation during non-convert time.

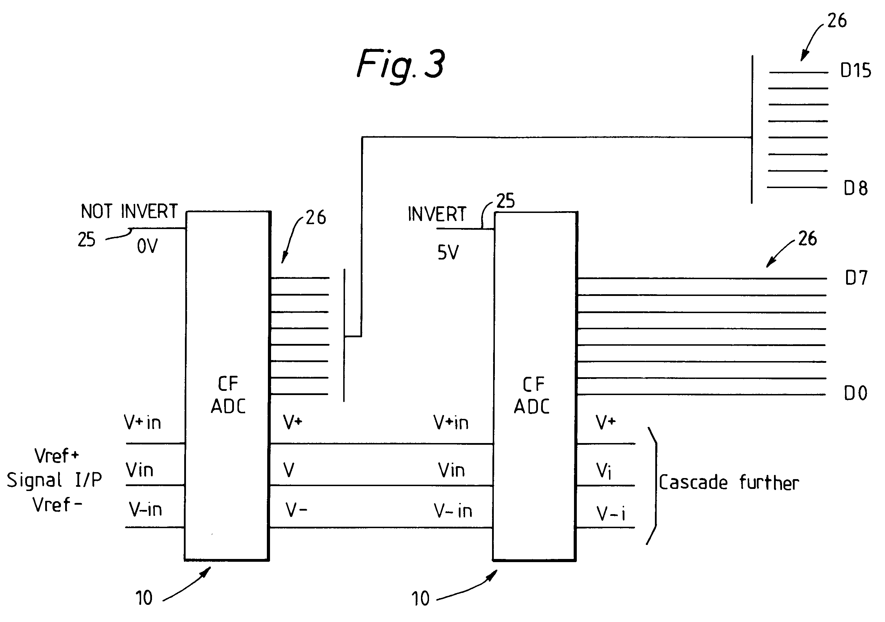

Referring now to Figure 3, two analogue to digital converters of the type shown in Figure 1 are cascaded together to provide an 16 bit converter. As seen in the Figure, the output of the second 8 bit converter may be cascaded further if greater resolution is required.

In the version of Figure 1, using a resistor reference, an analogue reference output set of signals (V₊ₒᵤₜ and V₋ₒᵤₜ) is generated by measuring and amplifying the analogue voltages directly across the input resistor in the resistor chain relevant to the comparator immediately above the highest comparator set. In both Figure 1 and Figure 2 versions, an amplified analogue voltage (Vₒᵤₜ) is generated which indicates the position of the analogue signal within the subrange defined by the particular comparator. In this way, a cascadable design is implemented whereby any number of bit analogue digital converter conversions may be accomplished at "flash" speeds, limited only by the physical limitations of the technology, (e.g. amplifier offset voltages, leakage currents).

The capacitor reference version uses as a cascade reference, the sum of the subreferences. Thus, in both designs, by combining two or more cascades within the same monolithic chip (or several monolithic chips), an effective wide bit flash analogue digital converter design may be achieved using several orders of magnitude fewer circuit elements than conventional designs, and in so doing making the circuit a practical proposition with current technology.

## Claims

1. An analogue to digital converter for converting an analogue input signal which lies within an analogue input range, characterised in that said converter (10, 40) comprises a stack of comparator circuits (12, 42) each corresponding to a subrange of said analogue input range, wherein said converter (10, 40) is operable to provide a digital output signal defining the subrange containing said analogue input signal (Vᵢₙ), and an analogue output signal or signals defining the position of said analogue input signal within said subrange, said analogue output signal or signals being derived from the inputs to said comparator circuits (12, 42).

2. An analogue to digital converter for converting an analogue input signal (Vᵢₙ) which lies within an analogue input range, characterised in that said converter (10) comprises:-
a stack of comparator circuits (12, 42) each including two inputs and an output;
input means for supplying said analogue input signal (Vᵢₙ) to said comparator circuits for comparison;
subreference generating means (16, 44) for providing a scale of subreference signals defining a plurality of subranges of said analogue input range and for supplying said subreference signals to corresponding comparator circuits;
digital output means responsive to the output stages of said comparator circuits (12, 42) for providing a digital number corresponding to the subrange containing the analogue input signal, and analogue output means (28) responsive to the state of the comparator circuits for providing an analogue output signal or set of signals (V₊ₒᵤₜ, Vₒᵤₜ, V₋ₒᵤₜ) which is or are derived from at least one of the subreference signals defining the subrange containing said analogue input signal, and which indicates the position of said analogue signal within said subrange.

3. An analogue to digital converter according to Claim 2, wherein said analogue output means (28) provides an analogue output signal representing the difference between the analogue input signal and one of the subreference signals defining said subrange.

4. An analogue to digital converter according to Claim 2 or 3, wherein said analogue output means (28) provides an analogue output signal defining one of the upper and the lower limit of said analogue input range.

5. An analogue to digital converter according to any preceding claim, including analogue reference input means (16) for receiving reference signals (V₊ᵢₙ, V₋ᵢₙ) defining the upper and lower limits of said analogue input range.

6. An analogue to digital converter according to Claim 5 when dependent on Claim 2, wherein said subreference generating means is responsive to the reference signals supplied via said analogue reference input means to subdivide the analogue input range into said subranges.

7. An analogue to digital converter according to Claim 6, wherein said subreference generating means comprises a voltage dividing reference chain of resistive elements (16) in series.

8. An analogue to digital converter according to Claim 7, wherein each comparator circuit receives an upper subreference signal and a lower subreference signal tapped from either side of a corresponding resistive element in said chain, each circuit further comprising logic means operable to supply said upper and lower subreference signals to said analogue output means when the analogue input signal is within the subrange corresponding to said comparator circuit.

9. An analogue to digital converter according to Claim 6, wherein said subreference generating means (44) comprises a reference chain of capacitative elements (47) connected in series and means for charging each said capacitative elements with a voltage corresponding to an increment of said analogue input range.

10. An analogue to digital converter according to Claim 9, wherein said subreference generating means (44) includes switch means (48, 49) for alternately switching the reference chain between parallel and serial.

11. An analogue to digital converter according to Claim 9 or Claim 10, wherein the total voltage in use across the chain of capacitative elements (47) when charged corresponds to the analogue input range.

12. An analogue to digital comparator according to Claim 10 or 11, including means for controlling the voltages applied to said capacitative elements (47) whereby the total voltage across said chain is maintained equivalent to said analogue input range.

13. A cascaded converter comprising a plurality of analogue to digital converters (10, 40) according to any one of the preceding claims converted in cascade manner, whereby each analogue to digital converter effects a subconversion and the digital output signals are assembled to provide a composite high resolution output signal.

14. A cascaded converter according to Claim 13, wherein the digital output means of each analogue to digital converter (10, 40) includes an inverting priority encoder (24, 54) and the encoders of adjacent analogue to digital converters are set alternately to invert and not invert.
